(19) **Europäisches Patentamt**
**European Patent Office**
**Office européen des brevets**

(11) **EP 2 584 062 A1**

(12) # EUROPÄISCHE PATENTANMELDUNG

(43) Veröffentlichungstag:
**24.04.2013 Patentblatt 2013/17**

(51) Int Cl.:
**C23C 14/08** (2006.01)     **C23C 14/34** (2006.01)

(21) Anmeldenummer: **11008408.4**

(22) Anmeldetag: **19.10.2011**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**

(71) Anmelder:
- **Heraeus Materials Technology GmbH & Co. KG
  63450 Hanau (DE)**
- **Fraunhofer-Gesellschaft zur Förderung der
  angewandten Forschung e.V.
  80686 München (DE)**

(72) Erfinder:
- **Herzog, Andreas
  63486 Bruchköbel (DE)**

- **Schultheis, Markus
  36103 Flieden (DE)**
- **Schneider-Betz, Sabine
  63303 Dreieich (DE)**
- **Schlott, Martin, Dr.
  63075 Offenbach (DE)**
- **Dewald, Wilma
  38106 Braunschweig (DE)**

(74) Vertreter: **Brand, Normen
  Heraeus Holding GmbH
  Schutzrechte
  Heraeusstraße 12-14
  63450 Hanau (DE)**

(54) **Sputtertarget und seine Verwendung**

(57)     Die vorliegende Erfindung betrifft ein Sputtertarget mit einem mindestens zwei Phasen oder Komponenten enthaltenden Material. Eine Phase wird durch ein Metalloxid gebildet, welches die Matrix bildet, in das elementares Metall oder Metalllegierung eingebettet ist.

Das Sputtertarget zeichnet sich durch einen geringen Widerstand und eine hohe Dichte aus. Es ist geeignet zur Erzeugung von Schichten mit geringem Reflexionsvermögen und hohem Absorptionsvermögen.

EP 2 584 062 A1

**Beschreibung**

Die Erfindung betrifft ein Sputtertarget mit einem mindestens zwei Phasen oder Komponenten enthaltenden Material. Sie betrifft insbesondere ein Sputtertarget, das Oxid und elementares Metall enthält. Sie betrifft ferner die Verwendung solcher Sputtertargets.

Flüssigkristallbildschirme *(liquid crystal displays; LCDs)* und Absorberschichten für Solarthermieanwendungen sind aus der Elektronikindustrie seit langer Zeit nicht mehr wegzudenken. Sie finden Anwendung in weiten Bereichen von Informationstechnologien und es besteht ein stetiger Bedarf an größeren und hochauflösenden Bildanzeigen. Zur Verbesserung des Kontrastes von Displays sind seit den 1980er Jahren $CrO_x/Cr$ dünne optisch absorbierende Schichten entwickelt worden. Beispiele hierfür sind in US Patent Nr. 5,976,639 offenbart.

Die dünnen optisch absorbierenden Schichten werden üblicherweise durch Sputterdeposition *("Sputtern")* aufgebracht. Beim Sputtern werden Atome oder Verbindungen aus einem Festkörper, dem Sputtertarget, durch Beschuss mit energiereichen Ionen (üblicherweise Edelgasionen) herausgelöst und gehen in die Gasphase über. Die in der Gasphase befindlichen Atome oder Moleküle werden schließlich durch Kondensation auf einem in der Nähe des Sputtertargets befindlichen Substrat abgeschieden und bilden dort eine Schicht aus.

Wegen der Toxizität von Chrom besteht jedoch ein dringender Bedarf an Chrom freien Schichten. Aus diesem Grund wird stetig nach verbesserten Halbleitermaterialien gesucht. Als vielversprechende Alternativen erweisen sich insbesondere andere Oxide. So wird z.B. in US 6,387,576 B2 eine optisch absorbierende Schicht, eine sogenannte "black matrix" offenbart, die als dielektrisches Material SiO und zumindest ein weiteres Metall enthält, bei welchem es sich um Eisen, Kobalt, Vanadium oder Titan handelt. Dabei nimmt der Gehalt an SiO entlang der Einfallsrichtung des Lichts auf das Display ab, während der Gehalt des Metalls ansteigt. Die so erzeugten Schichten müssen eine Schichtdicke von mindestens 0,2 $\mu$m haben, um den optischen Anforderungen zu genügen.

Der vorliegenden Erfindung liegt daher die Aufgabe zugrunde, ein Sputtertarget bereitzustellen, das für die Herstellung optisch absorbierender, hochohmiger und elektrisch isolierender Schichten geeignet ist, welche bereits bei Schichtdicken von weniger als 0,2 $\mu$m ein ausreichend geringes Reflexionsvermögen und ein ausreichend hohes Absorptionsvermögen zeigen.

Diese Aufgabe wird gelöst durch ein Sputtertarget mit den Merkmalen des Anspruch 1. Es handelt sich um ein Sputtertarget mit einem mindestens zwei Phasen oder Komponenten enthaltenden Material, wobei ein reduziertes Metalloxid die Matrix bildet und elementares Metall oder eine Metalllegierung in die Oxidmatrix eingebettet ist. Die Aufgabe wird außerdem durch die Verwendung solcher Sputtertargets zur Herstellung optisch absorbierender hochohmiger Schichten gemäß Anspruch 11 gelöst.

Erfindungsgemäß ist unter reduziertem Metalloxid ein Metalloxid zu verstehen, das einen Sauerstoffmangel im Vergleich zur stöchiometrischen Zusammensetzung aufweist. Erfindungsgemäß bedeutet "Metalloxid bildet die Matrix", dass das Metalloxid zu mehr als 50 Vol.% bis 98 Vol.% vorliegt, es liegt bevorzugt zu mehr als 55 Vol% oder mehr vor. Das Metall oder die Metalllegierung liegt in der Matrix fein dispergiert vor. Es ist zu 2 bis weniger als 50 Vol%, bevorzugt von 2 Vol% bis zu 45 Vol% oder weniger vorhanden.

In einer besonders bevorzugten Ausführungsform enthält das erfindungsgemäße Target als Matrix Metalloxid zu 90 Vol.% - 98 Vol.% und elementares Metall oder Metalllegierung zu 2 Vol.% - 20 Vol.%.

Gemäß einer weiteren besonders bevorzugten Ausführungsform enthält das erfindungsgemäße Target als Matrix Metalloxid zu 55 Vol.% - 70 Vol.% und elementares Metall oder Metalllegierung zu 30 Vol.% - 45 Vol.%.

Das Metalloxid kann ein beliebiges reduziertes Metalloxid sein. Bevorzugt ist dieses Oxid ein Oxid der Gruppe 4-6 des Periodensystems der Elemente, bevorzugt aus der Gruppe ausgewählt, die aus Titanoxid in einer beliebigen Oxidmodifikation, Nioboxid in einer beliebigen Oxidmodifikation, Vanadiumoxid in einer beliebigen Oxidmodifikation, Molybdänoxid in einer beliebigen Oxidmodifikation, Tantaloxid in einer beliebigen Oxidmodifikation, Wolframoxid in einer beliebigen Oxidmodifikation oder einem Gemisch davon besteht. Besonders bevorzugt ist reduziertes Nioboxid, insbesondere $N_2O_{5-x}$.

Bevorzugt ist das in die Matrix eingebettete Metall Ag oder Al, besonders bevorzugt ist Ag. In die Matrix können gleichermaßen auch Metalllegierungen, vorzugsweise Metalllegierungen, die Ag oder Al enthalten, eingebettet sein.

Normalerweise sind Zweikomponentenwerkstoffe aus einem Oxid und einem Metall, bei welchem das Metall in einem Volumenanteil von nicht mehr als 20 % vorliegt, nicht leitfähig und können demzufolge nicht als DC-Sputtertarget verwendet werden. Erst oberhalb eines Volumenanteils von ca. 15 % - 30% abhängig von Morphologie und Menge der leitfähigen Phase bildet sich ein Perkolationsnetzwerk aus, so dass das Target leitfähig wird.

Erfindungsgemäß wird jedoch ein reduziertes Metalloxid eingesetzt, d.h. ein Metalloxid, das einen Sauerstoffmangel im Vergleich mit der stöchiometrischen Zusammensetzung aufweist. Damit ist das Sputtertarget leitfähig, auch wenn kein perkolierendes Metallnetzwerk ausgebildet wird. Bevorzugt hat es einen spezifischen elektrischen Widerstand von 1,5 $\Omega$cm oder weniger, besonders bevorzugt von 0,35 $\Omega$cm oder weniger, insbesondere von 0,1 $\Omega$cm oder weniger und ganz besonders bevorzugt von 0,05 $\Omega$cm oder weniger. Die untere Grenze eines spezifischen elektrischen Widerstands kann mit $10^{-5}$ $\Omega$cm angegeben werden.

Das Sputtertarget kann aus der oben beschriebenen Mischung bestehen. Andererseits kann diese Mischung auch auf einem Träger angeordnet sein. Der Träger kann beispielsweise aus Edelstahl beschaffen sein. Dieser Träger fungiert bei der Sputterdeposition üblicherweise als Kathode. Gemäß einer bevorzugten Ausführungsform ist diese Kathode eine planare Kathode oder eine Rohrkathode. Gemäß einer besonders bevorzugten Ausführungsform ist die Kathode eine Rohrkathode. Gegebenenfalls kann das Sputtertarget neben dem Träger und der Mischung weitere Bestandteile, insbesondere weitere Schichten, die beispielsweise zwischen dem Träger und der Mischung angeordnet sein können, aufweisen.

Gemäß einer bevorzugten Ausführungsform der Erfindung hat das Sputtertarget eine Dichte von > 85 %. Bevorzugt hat das Sputtertarget eine Dichte von > 95 %. Die Dichte [%] ist als das Verhältnis zwischen der scheinbaren Dichte $[g/cm^3]$ und der theoretischen Dichte $[g/cm^3]$ definiert.

Ein Verfahren zur Herstellung des erfindungsgemäßen Sputtertargets besteht darin, dass in einem ersten Schritt eine Mischung aus beiden Komponenten derart hergestellt wird, dass die Metallkomponente(n) fein dispergiert wird, so dass bevorzugt keine oder nur noch sehr kleine Agglomerate vorliegen und die Partikel eine mittlere Größe von höchsten 25 $\mu$m, aber auch bis zu etwa 50 nm, bestimmt mittels Laserbeugung haben. Aus dieser Pulvermischung wird dann über bekannte Herstellverfahren wie Sintern in inerter oder reduzierender Atmosphäre ein planares oder rohrförmiges Sputtertarget hergestellt. Als Herstellungsverfahren für solche im Sauerstoffgehalt unterstöchiometrischen Sputtertargets werden analog das Heißpressen in einer nichtoxidierenden Atmosphäre nach der JP-A-07-233469 oder ein reduzierendes Plasmaspritzverfahren nach der US 6,193,856 B1 eingesetzt.

Mischverfahren zur Herstellung von Pulvermischungen für Composite sind bereits bekannt. So kann ein Composite zum Beispiel durch Mischen eines substöchiometrischen Metalloxides $M^1O_{n-x}$ mit einem Metall $M^2$ auf der Partikelebene von tyischerweise 0,1-100 $\mu$m durch mechanisches Mischen in einem Mischaggregat, z.B. in einem Mischer der Fa. Eirich oder durch Sprühagglomerieren hergestellt werden. Hierbei gibt n die Oxidationsstufe von $M^1$ an.

Um potenzielle Seigerungen zu vermeiden, kann es vorteilhaft sein, Binder und/oder Wasser zuzugeben. Geeignete Binder sind dem Fachmann bekannt. Übliche Binder sind Polyvinylalkohol, Poyacrylate, Cellulose, etc.. Die Binderbestandteile können beim weiteren Herstellprozess als Kohlenstoffquelle für (weitere) Reduktion des Metalloxides dienen.

Die Mischung kann auch Kohlenstoff oder das entsprechende Metallhydrid enthalten. Beide Stoffe liegen bevorzugt in einer Partikelgröße von 0,05 - $1x10^2$ $\mu$m vor. Das Vorhandensein von feinverteilten Kohlenstoff oder Metallhydrid ermöglicht es, eine partielle Reduktion des Metalloxids im Werkstoff zu erzeugen. Reaktionsgase müssen während des Prozesses kontrolliert abgeführt werden.

Die Formgebung der entstandenen Pulvermischung erfolgt vorteilhaft durch uniaxiales Pressen oder CIP (cold isostatic pressing). Typische Pressdrücke sind im Bereich von 50-200 MPa. Im anschließenden Prozessschritt erfolgt ein Sintervorgang unter inerten Bedingungen zur Zieldichte. Die Sintertemperatur muss dabei auf die Schmelztemperatur des Metalls (M) oder der Metalllegierung angepasst werden, d.h. unterhalb der Schmelztemperatur des Metalls oder der Metalllegierung liegen. Im Beispiel von $Ag/Nb_2O_5$ heißt das unterhalb 960°C bleiben. Eventuelle Druckbeaufschlagung (Gas) kann die Sinteraktivität und damit die erreichbare Sinterdichte erhöhen. Es entsteht ein $M^1O_{n-x}/M^2$-Verbundwerkstoff, der weitestgehend isolierte Metallphasen enthält. Die Leitfähigkeit (Wärme, Elektrisch) wird durch die reduzierte Oxidphase gewährleistet.

Eine alternative Verdichtungsmethode der wie oben beschriebenen gemischten Pulver, stellt das Heißpressen dar. Parallel kann hierbei eine (weitere) Reduktion des Metalloxides in direktem Kohlenstoffkontakt erfolgen. Formgebung und Sintern erfolgen in einem Prozessschritt bei Drücken von 10-40 MPa. Die Sintertemperatur muss dabei ebenfalls auf die Schmelztemperatur des Metalls (M) oder der Metalllegierung angepasst werden.

Eine weitere alternative Verdichtungsmethode, der wie oben beschriebenen gemischten Pulver, stellt das HIP (Heißisostatpressen) Verfahren dar. Eine Reduktion des Metalloxids kann durch oben beschriebene Methoden erfolgen. Der Verdichtungsdruck beträgt 10-100 MPa und die Druckführung muss dem Sinterfortschritt angepasst werden. Die Sintertemperatur muss dabei auf die Schmelztemperatur des Metalls (M) oder der Metalllegierung angepasst werden.

Eine weitere Möglichkeit zur Darstellung des Verbundwerkstoffs bietet das Plasmaspritzen. Dabei wird ein wie oben beschrieben hergestelltes Pulvergemisch aus Metalloxid und Metall oder Metalllegierung in der entsprechend eingestellten Plasmaflamme reduziert und auf einen Träger appliziert. Vorteilhaft erweisen sich Partikelgrößen von 10 - 100 $\mu$m für das Metall oder die Metalllegierung, das Metalloxid und das reduzierte Metalloxid.

Überraschenderweise können mit Hilfe dieser Sputtertargets hochohmige, optisch absorbierende Schichten bereitgestellt werden, die für die Anwendung in Flüssigkristallbildschirmen geeignet sind.

Diese Schichten zeigen bereits bei Schichtdicken von bis zu 150 nm ein Absorptionsvermögen von annähernd 100 % und ein Reflexionsvermögen von weniger als 15 %.

Die Erfindung betrifft ferner die Verwendung des Sputtertargets zur Herstellung eines hochohmigen, optisch absorbierenden Schichtsystems unter die Verwendung eines solchen Sputtertargets.

Sie betrifft bevorzugt die Verwendung dieser Sputtertargets zur Herstellung eines hochohmigen, optisch absorbierenden Schichtsystems, in dem die Gesamtdicke aller optisch absorbierenden Schichten von 30 und 150 nm beträgt. Besonders bevorzugt ist ein Verfahren, in dem nacheinander zwei verschiedene Targets zur Herstellung eines Schichtsystems verwendet werden, wobei das erste Sputtertarget Nioboxid mit einem Volumenanteil von 80 bis 98 % und Silber in einem Volumenanteil von 2 bis 20 % enthält, und das zweite Sputtertarget Nioboxid mit einem Volumenanteil von 55 % bis 65 % und Silber mit einem Volumenanteil von 35 bis 45 % enthält

Die nachstehenden Beispiele sollen die Erfindung erläutern und nicht einschränkend verstanden werden:

Beispiel 1:

Eine Pulvermischung aus 94 Vol% $Nb_2O_{4,99}$ und 6 Vol% Ag mit einer mittleren Korngrösse von 25 $\mu$m wurde in einem Tubular-Mischer 1 h intensiv gemischt, so dass sich eine feine und monodisperse Verteilung der Ag-Partikel in $Nb_2O_{4,99}$ ergab. Anschlie-$\beta$end wurde diese Mischung zunächst durch kaltisostatisches Pressen zu einer Ronde mit einem Durchmesser von 75 mm und einer Höhe von 15 mm verpresst. Anschlie-$\beta$end wurde die Ronde durch Heißpressen bei 940°C und 20 MPa zu mehr als 85% seiner theoretischen Dichte verdichtet. Das Gefüge bestand aus einer $Nb_2O_{4,99}$-Matrix in die einzelne, vollständig desagglomerierte Ag-Partikel mit einer mittleren Korngrösse von 25 $\mu$m eingebettet waren.

Analog wird ein zweites Sputtertarget mit 60 Vol% $Nb_2O_{4,99}$ und 40 Vol% Ag hergestellt.

Unter Verwendung dieser Sputtertargets wird ein zweischichtiger Probendünnfilm auf ein Glassubstrat (mit einem Durchmesser von 50 mm und einer Dicke von 1,0 mm) aufgebracht. Auf das Glas wird zunächst eine 38 nm dicke Schicht mit 6 Vol.% Silber und anschließend eine 78 nm dicke Schicht mit 40 Vol.% Silber aufgebracht.

Das so abgeschiedene dünne Schichtsystem wird bezüglich des spektralen Reflexionsvermögens und der spektralen Durchlässigkeit bei Wellenlängen von 400 bis 800 nm unter Verwendung eines UV-VIS-NIR-Spektrophotometers V-570DS von JASCO gemessen. Das Absorptionsvermögen wird aus dem gemessenen Reflexionsvermögen und der gemessenen Durchlässigkeit gemäß der folgenden Gleichung berechnet:

$$\text{Absorptionsvermögen} = 100\% - (\text{Reflexionsvermögen} + \text{Durchlässigkeit})$$

Bei 580 nm beträgt das Reflexionsvermögen 5 % und die Durchlässigkeit 0,5 %. Damit wird das Absorptionsvermögen zu 99,5 % bestimmt.

**Patentansprüche**

1. Sputtertarget mit einem mindestens zwei Phasen oder Komponenten enthaltenden Material, **dadurch gekennzeichnet, dass** reduziertes Metalloxid die Matrix bildet und elementares Metall oder eine Metalllegierung in die Oxidmatrix eingebettet ist.

2. Sputtertarget nach Anspruch 1 **gekennzeichnet durch** Metalloxid in einer Menge von 55 Vol.% bis 98 Vol.% und Metall oder Metalllegierung in einer Menge von 2 Vol.% bis 45 Vol.%.

3. Sputtertarget nach Anspruch 2, **gekennzeichnet durch** Metalloxid in einer Menge von 90 Vol.% bis 98 Vol.% und Metall oder Metalllegierung in einer Menge von 2 Vol.% bis 10 Vol.%.

4. Sputtertarget nach Anspruch 2 **gekennzeichnet durch** Metalloxid in einer Menge von 55 Vol.% bis 70 Vol.% und Metall oder Metalllegierung in einer Menge von 30 - 45 Vol.%.

5. Sputtertarget nach einem der Ansprüche 1 bis 4, **gekennzeichnet durch** einen spezifischen elektrischen Widerstand von 1,5 $\Omega$cm oder weniger.

6. Sputtertarget nach einem der Ansprüche 1 bis 5, herstellbar durch Sintern unter inerten, reduzierenden Bedingungen.

7. Sputtertarget nach einem der vorhergehenden Ansprüche, **dadurch gekennzeichnet, dass** das Metalloxid aus Oxiden der Gruppe 4-6 des Periodensystems der Elemente ausgewählt ist, und das Metall aus Silber und Aluminium ausgewählt ist.

**8.** Sputtertarget nach Anspruch 7, **dadurch gekennzeichnet, dass** das Metalloxid Nioboxid und das Metall Silber sind.

**9.** Sputtertarget nach einem der vorhergehenden Ansprüche, **gekennzeichnet durch** eine Dichte von > 85 % der theoretischen Dichte.

**10.** Sputtertarget nach Anspruch 9, **gekennzeichnet durch** eine Dichte von > 95 %.

**11.** Verwendung von Sputtertargets nach einem der vorhergehenden Ansprüche in einem Verfahren zur Herstellung eines hochohmigen, optisch absorbierenden Schichtsystems.

**12.** Verwendung nach Anspruch 11 zur Herstellung eines hochohmigen, optisch absorbierenden Schichtsystems, in dem die Gesamtdicke aller optisch absorbierenden Schichten von 30 und 150 nm beträgt.

**13.** Verwendung nach Anspruch 11 oder 12, **dadurch gekennzeichnet, dass** nacheinander zwei verschiedene Targets zur Herstellung eines Schichtsystems verwendet werden, wobei das erste Sputtertarget Nioboxid mit einem Volumenanteil von 90 bis 98 % und Silber in einem Volumenanteil von 2 bis 10 % enthält, und das zweite Sputtertarget Nioboxid mit einem Volumenanteil von 55 % bis 70 % und Silber mit einem Volumenanteil von 30 bis 45 % enthält.

Europäisches
Patentamt

European
Patent Office

Office européen
des brevets

# EUROPÄISCHER RECHERCHENBERICHT

**Nummer der Anmeldung**

EP 11 00 8408

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | EP 2 116 631 A1 (APPLIED MATERIALS INC [US]) 11. November 2009 (2009-11-11) <br> * Spalte 3, Absatz 15 - Spalte 4, Absatz 24 * <br> * Spalte 7, Absatz 42 * <br> ----- | 1-3,5,7, 11 | INV. <br> C23C14/08 <br> C23C14/34 |
| A | WO 03/066928 A1 (SAINT GOBAIN [FR]; FANTON XAVIER [FR]; GIRON JEAN-CHRISTOPHE [DE]) 14. August 2003 (2003-08-14) <br> * Seite 2, Zeile 22 - Seite 3, Zeile 28 * <br> * Seite 4, Zeilen 20-34 * <br> * Seite 5, Zeile 21 - Seite 6, Zeile 2 * <br> ----- | 1-3,5,7, 11 | |
| A | WO 2009/133076 A2 (APPLIED MATERIALS INC A CORP O [US]; MUELLER JOACHIM [DE]; SEVERIN DAN) 5. November 2009 (2009-11-05) <br> * Seite 4, Zeilen 1-11,30-32 * <br> * Seite 5, Zeile 1 - Seite 6, Zeile 23 * <br> ----- | 1 | |
| A | KUBART T ET AL: "Influence of the target composition on reactively sputtered titanium oxide films", VACUUM, PERGAMON PRESS, GB, Bd. 83, Nr. 10, 16. Juni 2009 (2009-06-16), Seiten 1295-1298, XP026152057, ISSN: 0042-207X, DOI: 10.1016/J.VACUUM.2009.03.026 [gefunden am 2009-03-28] <br> * Seite 1296, linke Spalte, Absatz 2 * <br> ----- | 1 | **RECHERCHIERTE SACHGEBIETE (IPC)** <br><br> C23C |

Der vorliegende Recherchenbericht wurde für alle Patentansprüche erstellt

| Recherchenort | Abschlußdatum der Recherche | Prüfer |
|---|---|---|
| München | 30. November 2011 | Joffreau, P |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes
    Dokument

EPO FORM 1503 03.82 (P04C03)

# EP 2 584 062 A1

**ANHANG ZUM EUROPÄISCHEN RECHERCHENBERICHT
ÜBER DIE EUROPÄISCHE PATENTANMELDUNG NR.**

EP 11 00 8408

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-11-2011

| Im Recherchenbericht angeführtes Patentdokument | | Datum der Veröffentlichung | Mitglied(er) der Patentfamilie | | Datum der Veröffentlichung |
|---|---|---|---|---|---|
| EP 2116631 | A1 | 11-11-2009 | KEINE | | |
| WO 03066928 | A1 | 14-08-2003 | AT | 392493 T | 15-05-2008 |
| | | | AU | 2003222879 A1 | 02-09-2003 |
| | | | CN | 1628185 A | 15-06-2005 |
| | | | DE | 60320375 T2 | 04-06-2009 |
| | | | EP | 1472386 A1 | 03-11-2004 |
| | | | ES | 2305456 T3 | 01-11-2008 |
| | | | FR | 2835534 A1 | 08-08-2003 |
| | | | JP | 4464139 B2 | 19-05-2010 |
| | | | JP | 2005525463 A | 25-08-2005 |
| | | | PL | 208506 B1 | 31-05-2011 |
| | | | PL | 208859 B1 | 30-06-2011 |
| | | | RU | 2310012 C2 | 10-11-2007 |
| | | | US | 2005115828 A1 | 02-06-2005 |
| | | | WO | 03066928 A1 | 14-08-2003 |
| WO 2009133076 | A2 | 05-11-2009 | KEINE | | |

EPO FORM P0461

Für nähere Einzelheiten zu diesem Anhang : siehe Amtsblatt des Europäischen Patentamts, Nr.12/82

7

**EP 2 584 062 A1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5976639 A
- US 6387576 B2
- JP 7233469 A
- US 6193856 B1